**Europäisches Patentamt**

**European Patent Office**

**Office européen des brevets**

(19)

(11) **EP 1 333 325 A1**

(12) **EUROPEAN PATENT APPLICATION**

(43) Date of publication:
**06.08.2003 Bulletin 2003/32**

(51) Int Cl.⁷: $G03F\ 7/20$, $G21K\ 1/06$

(21) Application number: **02002429.5**

(22) Date of filing: **01.02.2002**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **CARL ZEISS SEMICONDUCTOR MANUFACTURING TECHNOLOGIES AG 73447 Oberkochen (DE)**

(72) Inventors:
- **Singer, Wolfgang, Dr. 73431 Aalen (DE)**
- **Antoni, Martin 73434 Aalen (DE)**
- **Wangler, Johannes 89551 Königsbronn (DE)**
- **Escudero Sanz, Isabel 2631 GP Nootdorp (NL)**

(74) Representative: **Dr. Weitzel & Partner Friedenstrasse 10 89522 Heidenheim (DE)**

Remarks:
The application is published incomplete as filed (Article 93 (2) EPC).

(54) **Optical element for forming an arc-shaped illumination field**

(57)     The invention relates to an optical Element for forming an arc-shaped field in a field plane of an illumination system for wavelengths $\leq$ 193nm, preferably $\leq$ 126nm, especially EUV-wavelengths, wherein

- the arc-shaped field has an axis of symmetry (100) and the field plane (16) is defined by a vector in y-direction, which is in parallel to the axis of symmetry and a vector in x-direction, which is orthogonal to the axis of symmetry said optical element comprises

- a plurality of mirror surfaces (12.1,12.2,12.3) each comprising an array of aspherical reflecting elements wherein

- said array of aspherical reflecting elements comprise a plurality of cylindrical mirrors with aspheric curvature in x-direction and

- said plurality of mirror surfaces are forming a nested mirror (10), wherein two adjacent mirror surfaces have a spacing $d_{space}$.

FIG.1

## Description

The invention relates to an optical element for forming an arc-shaped field in a plane of an illumination system for wavelengths ≤ 193 nm, preferably ≤ 157nm, most preferably ≤ 126 nm, especially in the EUV-range.

EUV-lithography constitutes one of the most promising candidates for next generation lithography. The evolution of semiconductor fabrication demands reduced feature sizes of 50 nm and beyond. This resolution is obtained by the application of a short wavelength of 13.5 nm and moderate numerical apertures of 0.2 to 0.3 on the image side. The image quality of the lithography system is determined by the projection optics as well as by the performance of the illumination system. The illuminator has to deliver invariant illumination across the reticle field in the object plane.

EUV imaging systems need to be realized as reflective optical systems. For this reason, an unobscured pupil and a highly corrected image field can only be achieved in a small radial range of the image plane. Hence the field shape is a ring-field with high aspect ratio of typically 2 mm (width) x 22 - 26 mm (arc length) at wafer level. The projection systems operates in scanning mode.

EUV illumination systems will in general be non-centred systems formed by off-axis segments of aspherical mirrors. The reflectivity of multilayer-coated surfaces is greater 65 % for normal incidence and greater 80 % for grazing incidence. In order to maximize throughput, the number of reflections has to be minimized and grazing incidence elements should be used whenever possible.

In general there are two kinds of illumination possible, critical illumination and Köhler illumination, according e.g. to Henry N. Chapman, Keith A. Nugent "A Novel Condensor for EUV Lithography Ring-Field Projection Optics" in SPIE, Vol. 3767, pp. 225- 235, July 1999.

Critical illumination is when the light source is imaged into the illumination plane, and the condensor pupil is imaged into the camera entrance pupil.

In Köhler illumination the condensor pupil is imaged onto the illumination plane, and the light source is imaged onto the camera pupil.

In hybrid systems the illumination is e.g. critical in one transverse dimension and Köhler in the other.

Several EUV-light sources are currently being discussed. They differ in system aspects, but also in important illuminator-related aspects. System aspects are e.g. output power, repetition rate, footprint. For the illumination system size and divergence of the radiating plasma, radiation characteristics and geometrical vignetting are relevant. The illumination design has to account for these properties.

For forming the arc-shaped field in the object plane of an illumination system several solutions are discussed.

According to e.g. US 6198793 B1 the field is formed by field mirrors.

In another concept discussed e.g. in Henry N. Chapman, Keith A. Nugent "A Novel Condensor for EUV Lithography Ring-Field Projection Optics" in SPIE, Vol. 3767, pp. 225 - 235, July 1999 a ripple plate condensor is used for forming the arc-shaped field. According to Henry N. Chapman the central idea of the ripple plate condensor is to use a flat mirror with gentle corrugations in one direction. When collimated light illuminates the plate at an angle other than normal incidence it gets redirected onto an arc. The incident light must be aligned along the direction of the grooves of the ripple plate; that is, the component of the incident vector in the plane of the ripple plate must be parallel to the grooves. The effect is the geometrical analogue of conical diffraction from a diffraction grating, which occurs when the grating is illuminated in a similar manner.

An illumination system comprising a ripple plate as field forming component is discussed in EP-A-1 037 113, JP 10-70058 and US 6186632.

A disadvantage of the system known from EP-A-1 037 113, JP 10-70058 and US 6186632 are the dimensions of the ripple plate. Since the rays of the light source are impinging the ripple plate under a grazing incidence angle the ripple plate as a field forming component according to EP-A-1 037 113, JP 10-70058 and US 6186632 has to be of elongated shape.

Object of the invention is to provide a field forming component for an illumination system for wavelengths ≤ 193 nm, which is reduced in size.

According to the invention said object is achieved by an field forming optical element according to claim 1. Said element is characterized in that a plurality of mirror surfaces forming a nested mirror and each of said mirror surfaces comprises a one dimensional array of aspherical reflecting elements.

In an advantageous embodiment said aspherical reflecting elements are of cylindrical shape.

Apart from the field forming component said invention provides for an illumination system comprising such a field forming component.

In principle there are two concepts of an illumination system for EUV lithography described in this invention. One concept provides critical illumination in scanning direction and the other non-critical illumination in scanning direction. Advantageously according to the invention the two illumination systems have been designed in such a way that the conversion from critical to non-critical involves only the replacement of one component in the system.

The light sources are advantageously a laser plasma source or a z-pinch-source. The emission properties assumed for these sources are given in table 1.

Table 1:

| Source | Diameter (mm) | Emission angle (rad) | Lagrange invariant (mmxrad) |
|---|---|---|---|
| Laser plasma (LPS) | 0.32 | $\pi/2$ | 0.25 |
| Z-pinch | 1.7 | $\pi/10$ | 0.27 |

According to the invention the arc-shaped field is formed by a plurality of ripple plates forming a nested mirror. Each surface of the nested mirror comprises a one dimensional array of aspherical reflecting elements, which are preferably of cylindrical shape in a direction orthogonal to the scanning direction of the system.

When such a nested mirror is illuminated with a collimated beam whose direction is parallel to the axis of e. g. the cylindric reflecting elements, light in the form of a cone is reflected.

Illumination of the nested mirror with a convergent or divergent beam is also possible with tapered ripple plates, as introduced in US 6,186,632 and WO 01/69321, which are incorporated herein fully by reference. The following description and derivation will be given for parallel ripple plates only, the derivation for a nested array of tapered ripple plates is straight forward.

The illumination system in a first embodiment of the invention is a system for critical illumination in scanning direction. In a prefered embodiment of the invention the illumination system comprises a light source unit comprising a collector unit, an element for forming an arc-shaped field, a first mirror for imaging the element for forming an arc-shaped field in a conjugated pupil plane and an imaging system for imaging said arc-shaped field in an object plane have been shown in WO 01/09681 which is incorporated by reference.

The collector unit comprises in a first embodiment a first collector mirror which is elliptical and produces an image of the light source before a second collector mirror of the collector unit. The second collector mirror is an off-axis parabolic mirror with focus at the image of the light source produced by the first collector mirror. The light reflected by the second mirror is a collimated light bundle, which will be divided in several light bundles by the next component in the system.

The next component in the system according to the invention is a nested mirror, each surface of the nested mirror comprises an array of aspherical reflecting elements. Said aspherical reflecting elements have a aspheric curvature in a direction orthogonal to the scanning direction.

Light reaches each surface of the nested mirror at near gracing incidence. The nested mirror is located at a conjugate plane of the entrance pupil of the projection optics. All layers or surfaces are identical.

The next component of the illumination system is an elliptical mirror, which images the nested mirror into a conjugate plane where pupil masks can be placed. If the mirror surfaces of the nested mirror are flat, this mirror would also make an image of the light source in a field plane, where e.g. field masks can be placed. This location is the image focus of the mirror, where all the bundles meet and focus. Since an image of the light source lies in a field plane in the scanning direction, the illumination is therefore a critical illumination in the scanning direction.

After the field plane, where e.g. the field masks could be placed, an imaging system comprising a set of two mirrors, a hyperbolic and elliptical mirror can be situated. Their role is to image the pupil masks into the entrance pupil of the projection objective and the field plane, where e.g. field masks can be situated, in the object plane, where e.g. a pattern bearing mask can be placed while keeping good imaging properties for both sets of conjugate planes.
Such imaging system is prefered, but not necessary. In an alternative embodiment without an imaging system, the field-plane is also the object-plane of the illumination system, where the mask or reticle could be situated.

In a second embodiment of the invention the illumination system is a non critical or a Koehler illumination in scanning direction. To change from the critical to the non critical illumination according to the invention only one component has to be changed: the second collector mirror. This change affects the role of some of the other components, namely the nested mirror and the first mirror, which images the nested mirror into a conjugate plane, in the direction of scanning, but it does not induce any changes in their shape. The optical components of the system from the light source to the entrance pupil of the projection optics are comprising a collector unit, an element for forming an arc shaped field, a first mirror for imaging the element for forming an arc shaped field in a field plane and if required an imaging system for imaging said arc shaped field from the field plane into the image plane. The first collector mirror of the collector unit is elliptical or a nested collector unit and produces an image of the light source before the second collector mirror.

The second collector mirror comprises in a prefered embodiment a one-dimensional array of aspheric mirrors. The tangential and sagittal curvatures of these mirrors are different, so as to yield converging beams in the tangential section and collimated beams in the sagittal section.
The tangential direction in said application refers to the scanning direction of a scanning lithography apparatus and the sagittal direction to the direction orthogonal to said scanning direction.

The light reflected by the second collector mirror is a collection of bundles parallel to each other, the bundles are converging towards secondary light sources in the direction of scanning. These are line-like light sources located at or near to the components of the nested mirror.

The next component in the system according to the invention is a nested mirror, each surface of said mirror comprises an array of aspherical reflecting elements. Light reaches each surface at near gracing incidence. The nested mirror is located at a conjugate plane of the entrance pupil of the projection optics.

The next component of the illumination system is an elliptical mirror. The elliptical mirror images the nested mirror into a conjugate plane where pupil masks can be placed. If the mirror surfaces in the nested mirror are flat mirrors, the flat mirrors would produce in the direction orthogonal to scanning an image of the light source in the field plane, where e.g. field masks can be placed. The field plane is also the image focus of the first mirror in the scanning direction. Therefore all the light bundles parallel to each other coming out of the second collector mirror and nested mirror are also directed towards the focus of the elliptic mirror but they are not focused there. In other words, illumination is no longer critical in scanning direction, since the image of the light source does not lie any longer in the field plane.

The remaining components of the system are identical to those described for the critical illumination concept. The invention is further described with reference to the figures. The figures show:

figure 1: show an arc-shaped field in a field plane

figure 2: an illumination system according to the invention with critical illumination in scanning direction and a imaging system for imaging a field plane within the illumination system in a object plane, where a pattern bearing mask is situated

figure 3: a detailed view of the nested mirror in a system according to figure 1

figure 4: a detailed three-dimensional view of a ripple plate

figure 5: an illumination system according to the invention with critical illumination in scanning direction

figure 6a to 6b: field in the field plane (16) (figure 6a) and in the object plane (28) for a, critical illumination system in scanning direction (figure 6b)

figure 7: an illumination system according to the invention with Koehler illumination in scanning direction

figure 8: a detailed view of the nested mirror in a system according to figure 7

figure 9: system according to figure 7 with coordinate system for deriving the mathematical equiations describing the second collector mirror.

figure 10: illumination system according to the invention with a z-pinch as a light source with small emission angle and Koehler illumination in scanning direction

figure 11: arc-shaped field for a illumination system according to figure 2 in the object plane

figure 12a to 12f: illumination of the pupil for different field points of the ring field according to figure 11

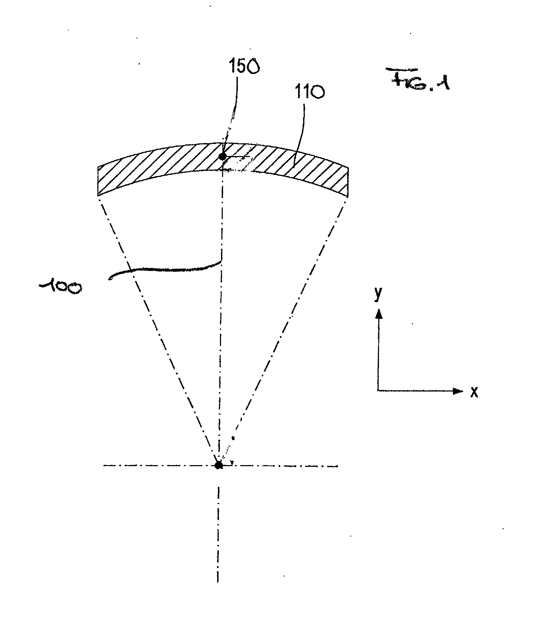

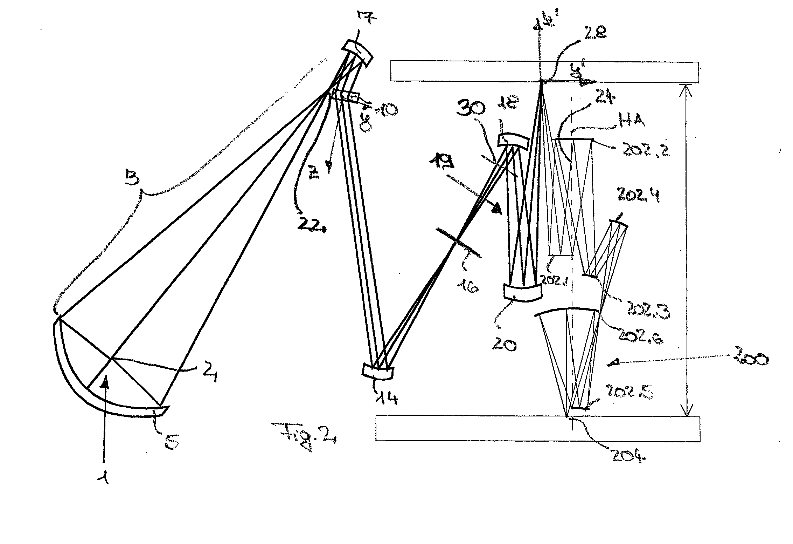

Figure 1 shows the principle shape of the field to be formed in the field plane or the object plane of the illumination system according to the invention. The field in the field plane or the object plane has the form of the segment of an arc-shaped field. The segment 110 has an axis of symmetry 100. Furthermore in figure 1 are depicted the x-axis and the y-axis, which are defining the field plane or the object plane. The axis of symmetry 100 of the arc-shaped field is parallel to the y-axis. Furthermore the y-axis coincidence with the scanning direction of a projection exposure apparatus in form of a ring field scanner. The x-axis is orthogonal to the y-axis. The central field point is denoted with the reference number 150.

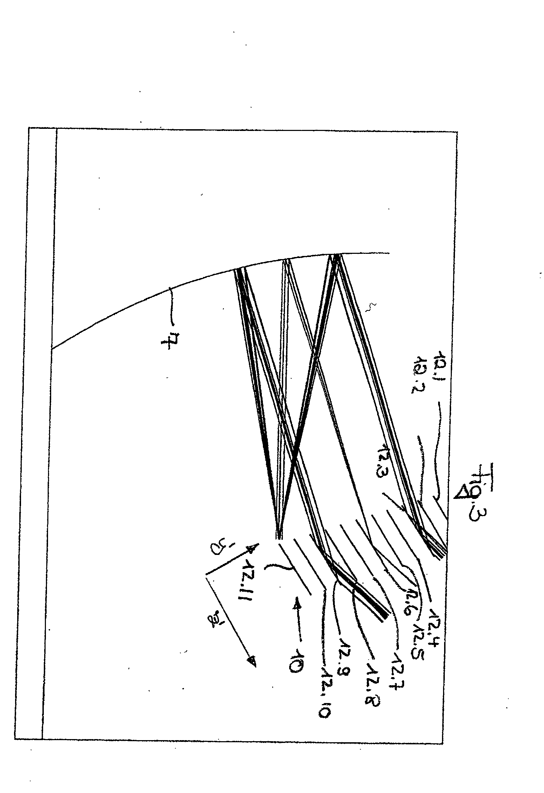

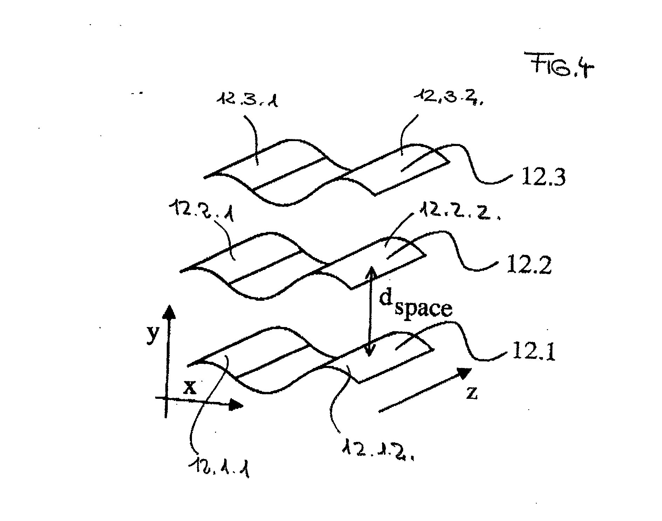

Figure 2 shows a projection exposure apparatus with an illumination system according to the invention with critical illumination in scanning direction. Said system comprises a light source unit 1 comprising in the embodiment shown a light source 2 and a collector unit 3. The collector unit 3 comprises a first and a second collector mirror 5, 7.The first collector mirror 5 forms the light emitted from a point-like light source 2 into a convergent light bundle 3. The convergent light bundle 3 is directed towards a second collector mirror 7. Both collector mirrors 5, 7 are normal incidence mirrors. The nested mirror 10 comprises a plurality of mirror surfaces. Such a nested mirror is shown in detail in figure 3. Each of said mirror surface comprises a one dimensional array of aspherical reflecting elements. The aspherical reflecting elements are of cylindrical shape. Each surface functions as a ripple plate. The system furthermore comprises a first mirror 14 situated before a field plane 16, in which a arc-shaped field is formed and an imaging system comprising a second mirror 18 and a third mirror 20 for imaging the field plane 16 into the object plane 28.

The two collector mirrors 5, 7 of the collector unit 3 form a Gregorian like system. The first collector mirror 5 is elliptical and produces an image 22 of the light source 1 before the second collector mirror 7. The second collector mirror 7 is an off-axis parabolic mirror with focus at the image 22 of the light source 1 made by first collector mirror 5. The light reflected by this mirror is thus a collimated bundle which will be divided in several by the next component, which is in this embodiment the nested mirror 10.

The nested mirror 10 comprises a plurality of cylindrical mirrors with aspherical curvature in sagittal direction. The sagittal direction corresponds to the x-direction.

Light reaching each surface 12.1, 12.2, 12.3, 12.4, 12.5, 12.6, 12.7, 12.8, 12.9, 12.10, 12.11 at near gracing incidence. This regards to an angle of 15 degrees in the current system. it can be reduced at the expense of making the overall system larger. The nested mirror 10 is located at a conjugate plane of the entrance pupil 24 of the projection optics not shown.

The nested mirror 10 as well as the second collector mirror 7 is shown in greater detail in figure 3. According to figure 3 all surfaces 12.1, 12.2, 12.3, 12.4, 12.5, 12.6, 12.7, 12.8, 12.9, 12.10 and 12.11 are identical. They are a collection of cylindrical mirrors. The cylinder axes are parallel to the z-direction of the local coordinate system. The light incident on these mirrors is collimated due to the shape of the second collector mirror 7. The light bundles incident on the nested mirror is divided in several bundles by this component. The separation between bundles is a consequence of the distance between layers and their finite thickness, which cause some vignetting. The effect of the nested ripple plate is to divide and change the shape of the light. It does not change the convergence in the scanning direction which corresponds to the y-direction, but it transforms the light from collimated to divergent or convergent in the x-direction, which is also called orthogonal direction. The result is a change in the cross section of the bundles from a rectangular to an arc shape.

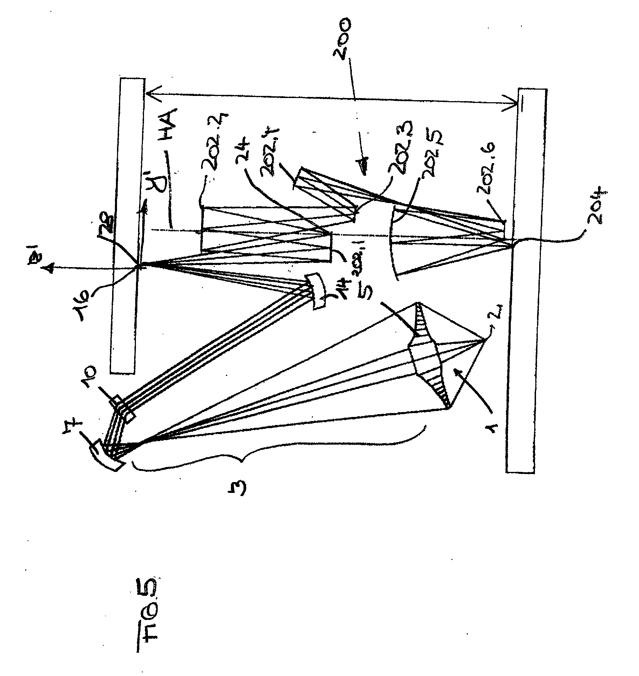

In figure 4 an embodiment of a nested ripple plate comprising three mirror surfaces 12.1, 12.2 and 12.3 in a three-dimensional view according to the invention is shown. Each mirror surface has two cylindrical mirrors 12.1.1, 12.1.2, 12.2.1, 12.2.2, 12.3.1, 12.3.2. The axis of the cylindrical mirrors are in parallel to the z-direction. Each cylindrical mirror has a aspherical curvature in sagittal direction, which corresponds to the x-direction which is orthogonal to the scanning direction. Each cylindrical mirror is a so called ripple. Two adjacent mirror surfaces have a spacing $d_{space}$ with 10 mm $\leq d_{space}$. After the nested mirror a first mirror 14, which is elliptical in the embodiment shown in figure 2, is situated. If the mirrors in the nest were flat, i.e. no power or ripples, the first mirror 14 would make an image of the light source 1 in the object plane 16. Since the plane 16 is a field plane, where REMA-blades or slit-defining masks could be situated, the illumination would be a critical illumination. With the mirror surfaces having ripples with optical power in sagittal direction, which is the direction orthogonal to the scanning direction and no optical power in scanning direction the illumination is critical only in scanning direction and Koehler orthogonal to scanning direction. Critical illumination in scanning direction means the image of light source 1 lies in the field plane 16 in scanning direction.

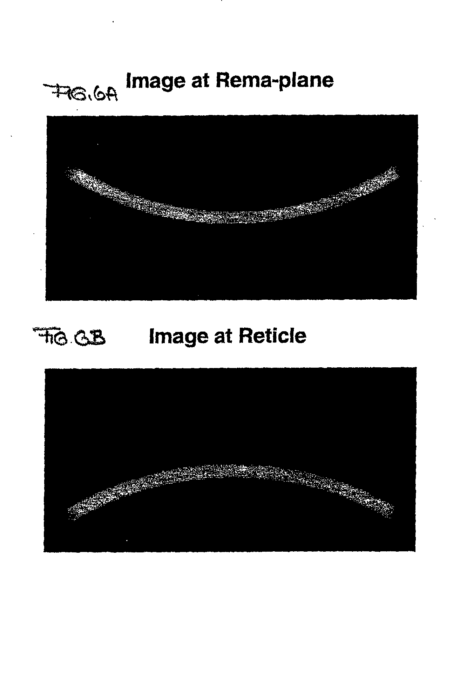

In the embodiment shown in figure 2 the plane 16, which is a field plane and where e.g. a REMA-blade or so called reticle-masking blade could be situated is imaged by a imaging system 19 comprising a second mirror 18 and a third mirror 20 into the object plane 28. The second mirror is hyperbolic and the third mirror elliptic. For the invention it is not necessary, that the field plane 16 is imaged by a imaging system in a object plane, where a reticle or a pattern bearing mask is situated. Alternatively the pattern bearing mask could directly by placed in the field plane 16. An imaging system then is superfluous, such a system is shown in figure 5.

A pupil mask could be placed in a conjugate plane 30 of the entrance pupil 24 of the projection optics 200. The projection optics in the embodiment shown in figure 2 comprises a six mirror projection objective. The projection objective comprises six mirrors 202.1, 202.2, 202.3, 202.4, 202.5 and 202.6 in centred arrangement to the optical axis HA. With the projection optics 200 the field in the object plane 28 of the illumination system, where e.g. a structured mask, a so called reticle, is situated is imaged onto a light sensitive object, e.g. a wafer in the image plane 204 of the projection objective. In the case of a ring field scanner the object, e.g. the reticle in the object plane 28 is scanned in the y-direction.

Figure 5 shows a further embodiment of the invention with critical illumination in scanning direction. Different to the system according to figure 2 is the first collector mirror 5, which is in case of figure 5 a nested mirror. Furthermore the system according to figure 5 has no imaging system comprising a second and a third mirror. The structured mask is placed directly in the field plane 16, which therefore in this embodiment becomes the object plane 28 of the projection optics 200. All other elements are identical to those in figure 2 and therefore denoted with the same reference numbers. The illumination system according to figure 5 is also a system with critical illumination in scanning direction.

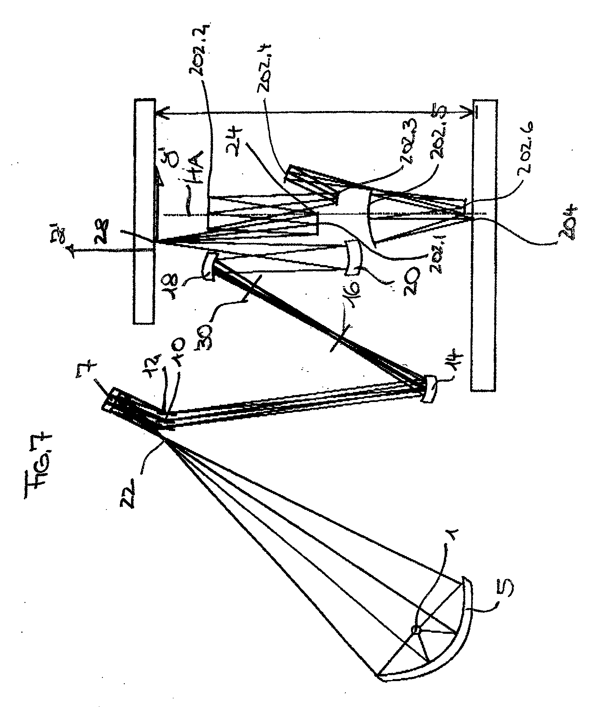

Figures 6a and 6b shows the field in the object plane 28, where e.g. the reticle is situated for a critical illumination system in scanning direction according to figure 2 or 5. Figure 6a shows the intensity distribution in plane 16 and figure 6b shows the intensity distribution in the object plane 28. Due to the negative magnification of the imaging system consisting of the second mirror 18 and the third mirror 20 the orientation of the arc is changed.

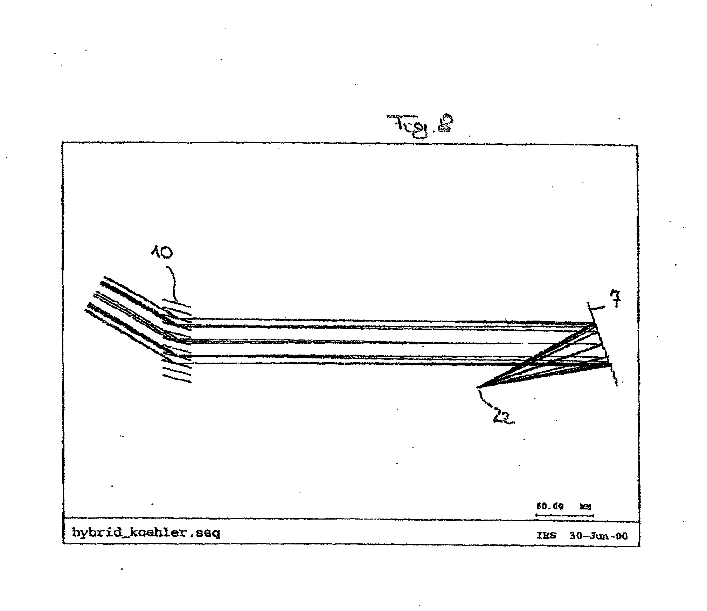

Figure 7 shows an illumination system according to the invention with Koehler illumination in y- or scanning direction.

According to the invention, if one goes from a critical to non-critical illumination system in scanning direction, one component has to the changed: the second collector mirror 7 of the collector unit. This change affects the role of some of the other components e.g. the nested mirror 10 and the first mirror 14 in the direction of scanning, but it does not induce any changes in their shape. The optical components of the system from light source to entrance pupil of projection optics are shown in figure 7. As far as the same components are concerned as in figure 2 and 5 the same reference numbers are used.

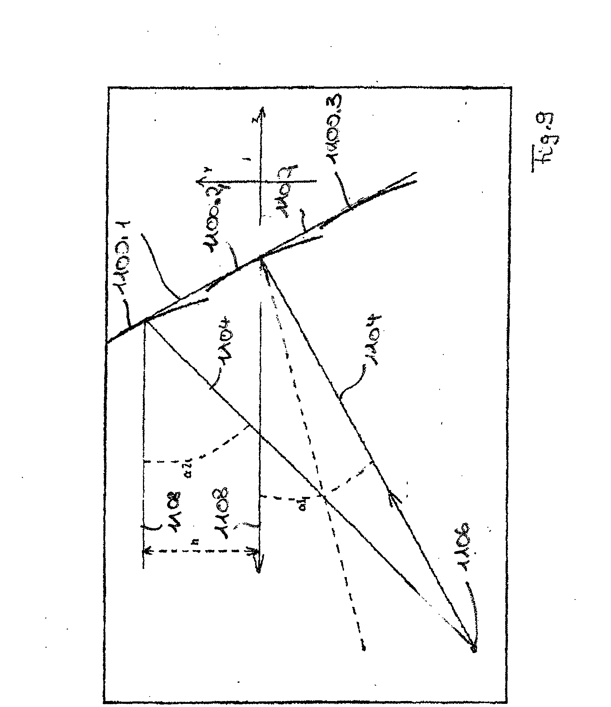

The first collector mirror 5 is elliptical and produces an image 22 of the light source 1 before the second collector mirror 7. The second collector mirror 7 comprises an one-dimensional array of aspheric mirrors. The tangential and sagittal curvatures of these mirrors are different, so as to yield converging beams in the tangential section and collimated beams in the sagittal section. In this application the tangential direction corresponds to the y-direction or the scanning direction and the sagittal direction to the x-direction orthogonal to the scanning direction of a scanning projection apparatus. The light reflected by the second collector mirror 7 is a collection of bundles parallel to each other, the bundles are converging towards secondary light sources in the direction of scanning. These are line-like sources located at or near to the nested mirror 10 comprising an array of aspherical reflecting elements. A detailed view of the second collector mirror 7 and the nested mirror 10 is given in figure 8.

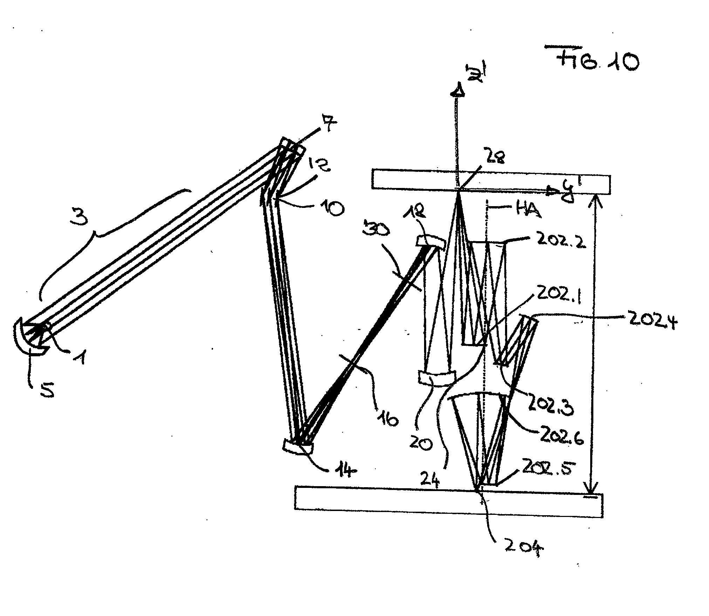

The shape of the second mirror according to the invention for Koehler illumination at least in one dimension comprises an one-dimensional array of aspheric mirrors which are also denoted as asphenic mirror facets that are located near to each other in the scanning direction. The elements are located in a reference plane 1102 so as shown in figure 9. Each miror 1100.1, 1100.2, 1100.3 is tilted with respect to the reference plane 1102, such that the incident light 1104 from the image of the light source 1106 made by the first collector mirror 5 is directed in a direction in which a flat mirror should be tilted to reflect light in a predetermined direction 1108. Alternatively, they could also be located in a curved reference surface and this could be used to control ellipticity of the pupil. The distance between the reference plane and the image 22 of the source 1 by the first collector mirror 5 is equal to the focal length of a parabola that would give a collimated beam with the appropriate diameter to fill the aperture of the nested mirror 10.

If one assumes a right-handed x, y, z co-ordinate system as shown in figure 9: with

the origin at the intersection of the optical axis of first collector mirror 5 with the central mirror of the second collector mirror 7,

the z-axis coinciding with the direction of reflection of the light by the second collector mirror being positive when opposite to reflection,

the x-axis being orthogonal to the z-axis and to the scanning direction

the y-axis being orthogonal to the z- and x-axis

and the components corresponding to identical components as in figures 7 and 8 are denoted by the same reference number, then a system comprising individual mirror elements that make the second collector mirror 7 can be described by the equation:

$$z = \frac{c(x^2 + y^2)}{1 + \sqrt{1 - c(x^2 + y^2)}} + px^2 \qquad (1)$$

c is the curvature of a spherical mirror that would make an image of the light source at the location of the nested mirror 10 when working on axis, and p is given by

$$p = \frac{1}{2c} - \frac{1}{4f} \qquad (2)$$

In this equation f is the distance between the image 22 of the source 1 by the first collector mirror 5 and the second collector mirror 7 along the principal ray. In principle, the values of c and p vary from mirror to mirror in order to control individually the convergence of the light, but, in first approximation, the system works also with identical values for all mirrors.

The effect of each element of the second collector mirror is to collimate the light in the x-direction orthogonal to scanning and to focus it on to the elements of the nested mirror 10 - the so called nested ripple plate - in the y-direction of scanning.

According to the invention the nested mirror 10 acts as a field forming component. Each surface of the nested mirror 10 functions as a ripple plate. The light reaches surface at near gracing incidence. In the current system the angle is 15 degrees. It can be reduced at the expense of making the overall system larger. The nested mirror is located at a conjugate plane of the entrance pupil of the projection optics. Shape and dimensions are as described for critical illumination systems. The light incident on the mirror surfaces of the nested mirror is collimated orthogonal to scanning direction; thus in x-direction and converging in scanning direction, thus the y-direction. The effect of the nested mirror is to change the shape of the light bundles coming out of the second collector mirror. The result is a change in the cross section of the bundles from a rectangular to an arc shape.

The first mirror 14 in figure 7 is an elliptical mirror. It images the nested mirror 10 in to a plane 30 where pupil masks can be placed. If the mirror in the nest do not have optical power or ripples, the first mirror 14 would also make, in the direction orthogonal to scanning, an image of the light source at a location where field masks can be placed. This location is the image focus of the first mirror 14. In the scanning direction, all the light bundles parallel to each other coming out of the second collector mirror 7 and nested mirror 10 are also directed towards the focus of the mirror 14 but they are not focused there. In other words, the illumination is no longer critical in scanning direction. With the mirror surfaces having ripples with optical power in sagittal direction which is the direction orthogonal to the scanning direction and no optical power in scanning direction the illumination is a Koehler illumination also in the x-direction orthogonal to the scanning direction. This means after the nested mirror 10 with ripples the illumination is Koehler in x- as well as in y- direction. The non-critical or Koehler illumination in scanning direction is due to the one-dimensional array of aspheric mirrors with aspheric curvature in scanning direction on the second collector mirror 7 and the non critical illumination orthogonal to the scanning direction is due to the ripples on the mirror surfaces with optical power in sagittal direction orthogonal to the scanning direction.

The remaining components of the system are identical to those described for the critical illumination concept in scanning direction in figures 2 and 5.

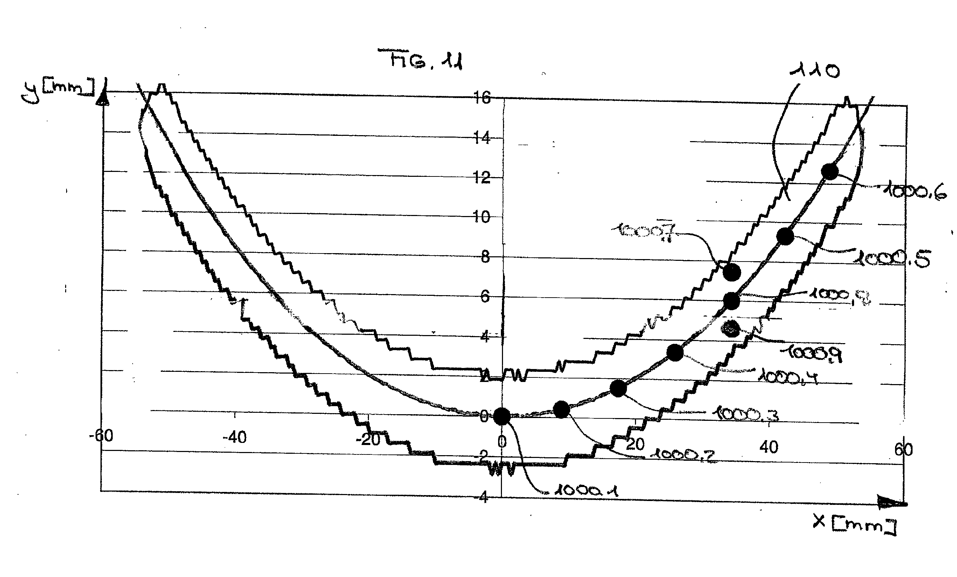

When the light source has a small emission angle, as e.g. the z-pinch sources, it is possible, in principle, to use a different collector unit then described above. For critical illumination in scanning direction this unit can be a simple parabolic mirror producing a collimated beam onto the nested mirror. For non critical illumination in scanning direction a second collector mirror is required. It is a second collector mirror similar to the one used for the laser plasma source described in the embodiment shown in figures 7 to 9. Because due to the small emission angle of the light source the individual mirror elements of the second collector mirror must not have any power in the x-direction so that the light in that azimuth is still collimated after the mirror. In the y-direction, the so called scanning direction they have power e.g. a spherical or parabolic shape to focus the light into secondary light sources. As in the case of the laser plasma source (LPS) described before an image of the collector source is produced on to the nested mirror 10 with the second collector mirror in scanning direction. The layout of such a system is shown in figure 10. All components which are similar or identical to the components in the embodiments shown in figures 2 and 5 for the critical illumination and figure 7 for the hybrid illumination are denoted with the same reference numbers.

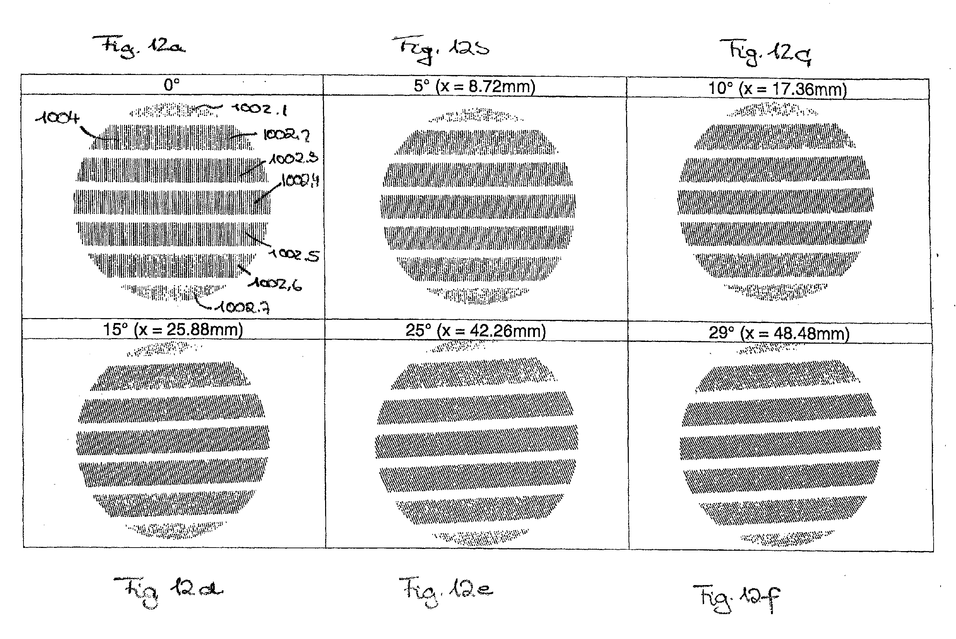

Figure 11 shows the field in the object plane 28 of the illumination system according to figure 2 with critical illumination in scanning direction. In the object plane 28 a structured mask is placed. The field in the object plane is arc-shaped. The y-direction is the scanning direction and the x-direction the direction orthogonal to the scanning direction. Furthermore several field points 1000.1, 1000.2, 1000.3, 1000.4, 1000.5, 1000.6, 1000.7, 1000.8 and 1000.9 are depicted. The field point 1000.1 is the field point in the centre of the arc-shaped field, which corresponds to the reference number 150 of figure 1.

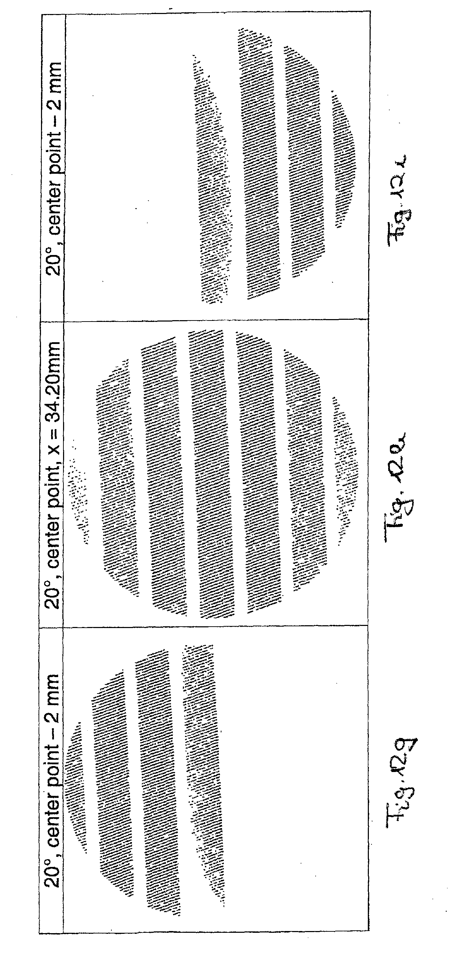

In figures 12a to 12i the intensity distribution in the exit pupil 24 of the illumination system of figure 2, which correspond with the entrance pupil of the projection objective is shown. Figure 12a is the exit pupil for the centre field point 1000.1. Figure 12b is the exit pupil of the field point 1000.2. Figure 12c is the exit pupil of the field point 1000.3, figure 12d is the exit pupil of the field point 1000.4, figure 12e is the exit pupil of the field point 1000.5, figure 12f is the exit pupil of the field point 1000.6, figure 12g is the exit pupil of the field point 1000.7, figure 12h is the exit pupil of the field point 1000.8 and figure 12i is the exit pupil of the field point 1000.9. The field points 1000.1 - 1000.9 are shown in figure 11.

As is apparent from figures 12a to 12i the pupil filling is discrete.

It consists of bands 1002.1, 1002.2, 1002.3, 1002.4, 1002.5, 1002.6, 1002.7 of lines. The bands are almost orthogonal to the scanning direction. The lines 1004 are almost parallel to the scanning direction. Each band corresponds to one layer of the nested mirror, which in the case shown consists of seven mirror surfaces. Each line within a band corresponds to a ripple.

The telecentricity does not vary significantly. A simulation of the pupil illumination by two scanning lines, one in the centre of the field and one at the edge show that the effect of moving from central line to the edge is not so much a displacement of the illumination but a rotation. This is shown in figures 12a to 12f. The illumination pattern is clearly rotated. The bands appear to be tilted with respect to those of the central line.

The field uniformity is controlled by the aspherical shape of the ripples. A uniform intensity distribution after scanning integration is achieved by consideration of the different length of the intensity distribution of the arc in scanning direction as well as the influence of aperture stops.

The advantages of the illumination system and the nested mirror with Köhler illumination in scanning direction according to the invention are as follows: The second collector mirror has one component for each layer of the nested mirror. Thus, they are organised in channels each producing a secondary light source. These light sources are situated on the ripple plate whereas a field plane is situated at the image focus of the first mirror.

As explained above, the light bundles leaving the second collector mirror are converging and collimated in scanning and orthogonal to scanning directions respectively. This is possible with a Gregorian-like configuration when selecting the appropriate combination of the curvatures of the second collector mirrors and the distance between the second collector mirror and the ripple plate.

The angular size of the image of the source by the first collector mirror which is seen by the second collector mirror must be small in order to reduce cross-talk losses between different channels. This affects the magnification of the first collector mirror.

In the case of critical illumination in scanning direction, it is impossible to avoid vignetting at the ripple plate whereas this is possible with non-critical illumination. The magnification of the collector unit in the scanning direction is chosen such that the width of the secondary line sources matches the width of the layers of the nest and so light does not need to be lost.

The pupil ellipticity can be controlled by the location of the individual mirrors of the second collector mirror.

Reference list:

| | |
|---|---|
| 1: | light source unit |
| 2: | light source |
| 3: | collector unit |
| 5: | first collector mirror |
| 7: | second collector mirror |
| 10: | nested mirror |
| 12: | surfaces of the nested mirror |
| 12.1, 12.2, 12.3, 12.4, 12.5, 12.6, 12.7, 12.8, 12.9, 12.10, 12.11: | single surfaces of the nested mirror |
| 12.1.1, 12.1.2, 12.2.1, 12.2.2, 12.3.1, 12.3.2: | cylindrical mirrors |
| 14: | first mirror |
| 16: | field plane |
| 18: | second mirror |
| 20: | third mirror |
| 22: | image of the light source |
| 24: | entrance pupil of the projection objective |
| 28: | object plane |
| 30: | conjugate plane for pupil mask |
| 100: | axis of symmetry of the arc shaped field |
| 200: | projection optics |
| 202.1, 202.2, 202.3, 202.4, 202.5, 202.6: | mirrors of the projection objective |
| 1000.1, 1000.2, 1000.3, 1000.4, 1000.5, 1000.6, 1000.7, 1000.8, 1000.9: | field point 5 of the arc-shaped field |
| 1002.1, 1002.2, 1002.3, 1002.4, 1002.5, 1002.6, 1002.7: | band of lines |
| 1004 | lines |
| 1100.1, 1100.2, 1100.3, | mirror facet |

**EP 1 333 325 A1**

| 1102 | reference plane |
| 1104 | incident light |
| 1106 | light source |
| 1108 | predetermined direction |

**Claims**

**1.** Optical Element for forming an arc-shaped field in a field plane of an illumination system for wavelengths $\leq$ 193 nm, preferably $\leq$ 126 nm, especially EUV-wavelengths, wherein

1.1 the arc-shaped field has an axis of symmetry (100) and the field plane (16) is defined by a vector in y-direction, which is in parallel to the axis of symmetry (100) and a vector in x-direction, which is orthogonal to the axis of symmetry

said optical element comprises

1.2 a plurality of mirror surfaces (12, 12.1, 12.2, 12.3, 12.4, 12.5, 12.6, 12.7, 12.8, 12.9, 12.10, 12.11) each comprising an array of aspherical reflecting elements wherein

1.3 said array of aspherical reflecting elements comprise a plurality of cylindrical mirrors with aspheric curvature in x-direction and

1.4 said plurality of mirror surfaces are forming a nested mirror (10), wherein two adjacent mirror surfaces have a spacing $d_{space}$.

**2.** Optical element according to claim 1, wherein

the spacing between two adjacent mirror surfaces is in the range of 10 mm $\leq d_{space}$.

**3.** Illumination system for wavelengths $\leq$ 193 nm, preferably $\leq$ 126 nm, with a light source unit (1) emitting a light bundle, especially in the EUV-wavelength region range comprising

3.1 an optical system for illuminating a field plane (16) with an arc-shaped field wherein

3.2 said optical system comprises a optical element according to one of the claims 1 to 2 for forming an arc-shaped field in said field plane (16).

**4.** Illumination system according to one of the claim 3, wherein said light source unit (1) comprises a collector unit (3).

**5.** Illumination system according to claim 4, wherein said collector unit (3) comprises a second collector mirror (7).

**6.** Illumination system according to claim 5, wherein the second collector mirror (7) comprises a plurality of mirror facets.

**7.** Illumination system according to claim 6, wherein each of the mirror facets is associated to a mirror surface of the nested mirror (10).

**8.** Illumination system according to one of the claims 6 to 7, wherein on said second collector mirror (7) said plurality of mirror facets are arranged in a one-dimensional array of aspherical reflecting elements wherein said aspherical reflecting elements provide a plurality of light bundles in y-direction , which impinges onto the optical element for forming a arc shaped field.

**9.** Illumination system according to one of the claims 4 to 8, wherein said collector unit (3) comprises a first collector mirror (7).

**11.** Projection exposure unit especially for microlithography comprising

11.1 an illumination system according to at least one of the claims 3 to 9 with an exit pupil

11.2 a mask on a carrier system, said mask be positioned in the object plane (28) of said illumination system

11.3 a projection objective with an entrance pupil (24), said entrance pupil (24) being in the same plane as the exit pupil of the illumination system, imaging said mask being positioned in the object plane (2) into a image plane, where

11.4 a light sensitive object on a carrier system is situated

**12.** Projection exposure unit according to claim 11 designed as a scanning system.

**13.** Process for produce a microelectronic device especially semiconductor chips with a projection exposure unit according to claim 11 to 12.

150

110

FIG.1

100

y

x

Fig.2

EP 1 333 325 A1

Fig. 3

FIG.4

FIG.5

FIG. 6A **Image at Rema-plane**

FIG. 6B **Image at Reticle**

FIG. 7

Fig. 8

hybrid_koehler.seq

50.00 kg

IHS 30-Jun-00

Fig. 9

FIG. 10

FIG. 11

Fig. 12a

0°

1004

1002.1
1002.2
1002.3
1002.4
1002.5
1002.6
1002.7

Fig. 12b

5° (x = 8.72mm)

Fig. 12c

10° (x = 17.36mm)

Fig. 12d

15° (x = 25.88mm)

Fig. 12e

25° (x = 42.26mm)

Fig. 12f

29° (x = 48.48mm)

| 20°, center point – 2 mm | 20°, center point, x = 34.20mm | 20°, center point – 2 mm |
|---|---|---|

Fig. 12g

Fig. 12e

Fig. 12i

**European Patent Office**

## EUROPEAN SEARCH REPORT

Application Number

EP 02 00 2429

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 627 667 A (AT & T CORP) 7 December 1994 (1994-12-07) * column 4, line 58 - column 5, line 4 * * column 5, line 19 - line 31 * * column 6, line 48 - line 54 * * column 7, line 10 - line 18 * * column 8, line 50 - column 9, line 15 * * figures 4,5 * | 1-13 | G03F7/20 G21K1/06 |
| D,A | CHAPMAN H N ET AL: "NOVEL CONDENSER FOR EUV LITHOGRAPHY RING-FIELD PROJECTION OPTICS" PROCEEDINGS OF THE SPIE, SPIE, BELLINGHAM, VA, US, vol. 3767, 1999, pages 225-236, XP000938184 * abstract; figures * | 1,3,11, 13 | |

TECHNICAL FIELDS SEARCHED (Int.Cl.7)

G02B
G03F
G21K
H01L

The present search report has been drawn up for all claims

| Place of search | Date of completion of the search | Examiner |
|---|---|---|
| THE HAGUE | 15 October 2002 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

**ANNEX TO THE EUROPEAN SEARCH REPORT
ON EUROPEAN PATENT APPLICATION NO.**                EP 02 00 2429

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2002

| Patent document cited in search report | Publication date | Patent family member(s) | Publication date |
|---|---|---|---|
| EP 0627667 A | 07-12-1994 | US 5439781 A<br>CA 2121608 A1<br>EP 0627667 A1<br>JP 6333798 A | 08-08-1995<br>11-11-1994<br>07-12-1994<br>02-12-1994 |